Europäisches Patentamt

European Patent Office

Office européen des brevets

(11) Veröffentlichungsnummer: **0 240 684 B1**

# EUROPÄISCHE PATENTSCHRIFT

(45) Veröffentlichungstag der Patentschrift: **29.01.92**

(21) Anmeldenummer: **87102639.9**

(22) Anmeldetag: **25.02.87**

(51) Int. Cl.⁵: **G01R 31/34**

(54) **Einrichtung zum betriebsmässigen elektronischen Verarbeiten von Betriebsdaten eines Elektromotors.**

(30) Priorität: **10.03.86 DE 3607878**

(43) Veröffentlichungstag der Anmeldung:
**14.10.87 Patentblatt 87/42**

(45) Bekanntmachung des Hinweises auf die
Patenterteilung:
**29.01.92 Patentblatt 92/05**

(84) Benannte Vertragsstaaten:
**DE FR GB SE**

(56) Entgegenhaltungen:
**EP-A- 0 181 775        DE-A- 3 226 169
DE-A- 3 424 692        DE-A- 3 441 644
FR-A- 2 538 558        GB-A- 2 122 749
GB-A- 2 150 774        US-A- 3 553 550
US-A- 4 307 455        US-A- 4 839 830**

**BBC BROWN BOVERI REVIEW**

(73) Patentinhaber: **SIEMENS AKTIENGESELL-
SCHAFT
Wittelsbacherplatz 2
W-8000 München 2(DE)**

(72) Erfinder: **Amey, Walter, Dipl.-Ing.
Lange Zeile 50
W-8520 Erlangen(DE)**
Erfinder: **Schneeberger, Reinhold
Kagenhoferweg 34
W-8501 Seukendorf(DE)**

# Beschreibung

Die Erfindung betrifft eine Betriebsdaten erfassungsvorrichtung mit einem Elektromotor.

Derartige Einrichtungen bzw. Verfahren sind zum Beispiel aus digitalen Drehzahlregelungen für Elektromotoren bekannt, wo Ist-Daten über Drehzahl, Drehwinkel, Motorstrom u.ä. fortlaufend erfaßt und miteinander sowie mit zugehörigen Sollwerten verknüpft werden, um die erforderlichen Stellsignale zu ermitteln und an die Stellglieder auszugeben. Im Rahmen dieser Verarbeitung werden die Ist- oder Betriebsdaten kurzzeitig, nämlich für wenige Taktzyklen, oder gar nicht - verglichen mit der Lebens- oder Einsatzdauer des Elektromotors jedenfalls höchstens punktuell - im Datenspeicher der Verarbeitungseinrichtung (zwischen-) gespeichert.

Bei Elektromotoren, die häufig bereits an sich hochwertige Investitionsgüter darstellen (z.B. Hochspannungsmotoren) oder von deren Verfügbarkeit die Effizienz kapitalintensiver Anlagen oder die Zuverlässigkeit von Sicherheitseinrichtungen abhängen, stellt sich nun z.B. das Problem der optimalen Einplanung von Revisionen, das heißt, diese sollen, um wirtschaftlich zu sein, in Abhängigkeit von der tatsächlichen Beanspruchung des jeweiligen Motors anstatt in starren Intervallen erfolgen.

Dazu bedarf es jedoch der Kenntnis dieser Beanspruchung über längere Zeitspannen der Lebens- oder Einsatzdauer des betreffenden Elektromotors, d.h. der Kenntnis seines Lebenslaufs. Biographische Ereignisse des Motors können aber mit den bekannten Einrichtungen und Verfahren wegen der dort höchstens punktuellen Speicherung der Betriebsdaten nicht rekonstruiert werden.

Aus der US 4,307,455 ist eine Vorrichtung zur Betriebsdatenerfasssung bei einem Kraftfahrzeug bekannt. Diese enthält eine Stromversorgungseinheit, welche es im Falle einer Störung der ordnungsgemäßen Energieversorgung ermöglicht, die Betriebsdatenerfassungsvorrichtung zumindest so lange weiterzubetreiben, bis die erfaßten Daten unverlierbar abgespeichert sind.

Demgegenüber liegt der Erfindung die Aufgabe zugrunde, die Betriebsdatenerfassungsvorrichtung so zu gestalten, daß im Normalbetrieb weder eine versehentliche noch eine böswillige Unterbrechung von deren Energieversorgung möglich ist.

Diese Aufgabe wird gelöst durch die Merkmale des Anspruchs 1.

Vorteilhafte Weiterbildungen der erfindungsgemäßen Einrichtung sind Gegenstand der Unteransprüche.

Die Erfindung hat somit den Vorteil, daß die Betriebsdatenerfassungsvorrichtung zuverlässig, ja zwangsweise, mit Energie versorgt wird, solange der zu überwachende Motor aktiv ist.

Der Vorteil der Erfindung besteht somit in einer ausfallsicheren, zumindest abschnittsweisen Rekonstruierbarkeit der Elektromotor-Biographie. Dabei wird ein Höchstmaß an Sicherheit gegen unbeabsichtige Abschaltungen bzw. gegebenenfalls absichtliche oder zumindest unbefugte Manipulationen an der Energieversorgung erreicht. Dies ist besonders wichtig für das bei einem etwaigen Störfall auftretende, insbesondere Fragen der Gewährleistung und Haftpflicht berührende Problem einer möglichst objektiven Ursachenfeststellung, da ein Ausfall eines Elektromotors in der Regel nicht das Ergebnis eines einzelnen Überlasteignisses ist, sondern oftmals auf einer Langzeitkumulation solcher Ereignisse - gegebenenfalls seit Inbetriebnahme - beruht. Die nunmehr gegebene, erfindungsgemäß energieversorgungsseitig gegen zufällige und/oder absichtliche Unterbrechungen geschützte Möglichkeit des Nachweises der anwenderseitigen Einhaltung bzw. Überschreitung der vom Hersteller vorgeschriebenen Motor-Betriebsbedingungen liegt gleichermaßen im Interesse des Abnehmers wie des Herstellers.

Die Pufferung der Energieversorgung der Einrichtung durch eine Langzeitbatterie entsprechend einer vorteilhaften weiteren Ausführung der Erfindung weist den Vorteil auf, daß auch bei fehlender Energieversorgung aus der Energieversorgungseinheit der Stand der Echtzeituhr aktuell bleibt und ein Verlust etwa flüchtiger Inhalte des Programmspeichers oder des Datenspeichers verhindert wird. Die eindeutige Zuordnung der Einrichtung zum Elektromotor zumindest für eine Spanne seines Lebens oder Einsatzes, gemäß gemäß einer weiteren Ausführung, dient der leichten, manipulationssicheren und eindeutigen Rekonstruierbarkeit der Biographie des betreffenden Motors.

Die weitgehende Spezialisierung des Anwendungszwecks der Einrichtung auf eine Registriertätigkeit, gemäß einer weiteren Ausführung beinhaltet die vorteilhafte Möglichkeit der separaten Erstausstattung oder Nachrüstung eines zu überwachenden Elektromotors unabhängig von dessen Steuerungs- und Regelungsmechanismus.

Die im Datenspeicher der Einrichtung gespeicherten biographischen Daten können entsprechend einer weiteren Ausführung vorteilhafterweise an ein externes Auslesegerät zur weiteren Verarbeitung und/oder Darstellung ausgegeben werden, um den Hardware- und Energieaufwand in der Einrichtung sowie auslesebedingte Motorstillstandszeiten zu minimieren.

Da während der Datenausgabe der Elektromotor normalerweise ruht und dann als direkte oder indirekte Energiequelle für die erfindungsgemäße Einrichtung während dieser Zeit nicht zur Verfügung steht, kann das externe Auslesegerät während des Ausgabevorgangs, etwa zur Schonung einer vorgesehenen Langzeitbatterie, gemäß einer weiteren Ausführung die Energieversorgung der Einrichtung vorteilhaft übernehmen.

Anhand eines in den Zeichnungen dargestellten Ausführungsbeispieles wird die Erfindung im folgenden näher erläutert. Es zeigen:

Fig. 1    eine Gesamtdarstellung einer erfindungsgemäßen Einrichtung mit einem zu überwachenden Elektromotor und einem externen Auslesegerät;

Fig. 2    ein Diagramm mit einem exemplarischen Zeitverlauf des Motorstroms;

Fig. 3    ein Beispielsschema für die Datenorganisation in und mittels der erfindungsgemäßen Einrichtung.

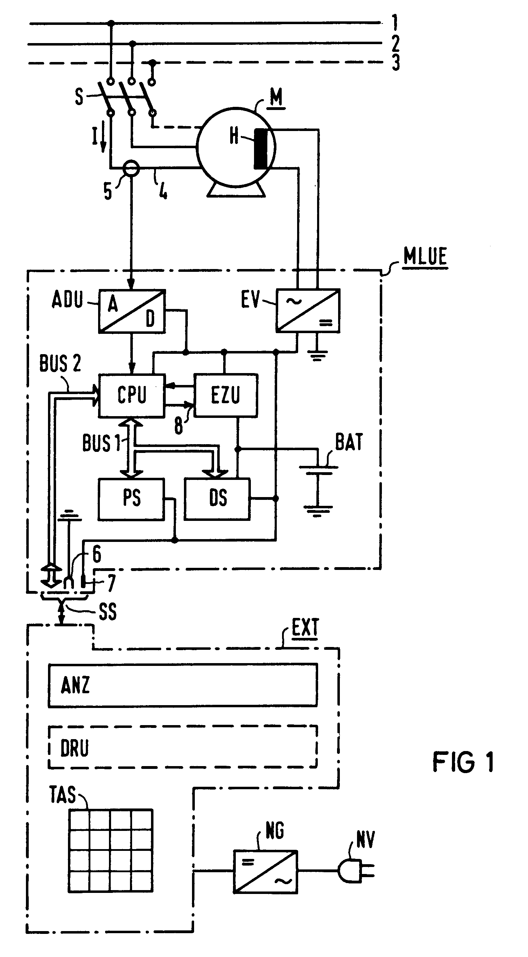

In der Anordnung nach Fig. 1 wird der Elektromotor M über einen Schalter S aus den Leitungen 1, 2 bzw. 1, 2, 3 mit elektrischer Energie gespeist, wobei es sich um hoch- oder niedriggespannten Gleich- oder Wechselstrom, gegebenenfalls mehrphasigen, handeln kann, ohne daß für die Anwendung der mit MLUE bezeichneten Einrichtung (Motor-Langzeit-Überwachung) Einschränkungen gelten. Dasselbe gilt für die Fälle, daß z.B. der Schalter S zur Umkehr der Motordrehrichtung als Umpoler mit mehreren Schaltstellungen ausgebildet ist oder mittels kontaktloser elektronischer Bauelemente, z.B. steuerbarer Gleichrichter, realisiert ist, wie etwa bei drehzahlgeregelten Antrieben.

Die Einrichtung MLUE überwacht Betriebsdaten des Elektromotors M, wobei Drehwinkel, Drehzahl, Drehbeschleunigung, Drehmoment, Leistung, thermische Belastung, Motorspannung, Motorstrom und sonstige mechanische und elektrische Betriebsdaten für eine Überwachung in Frage kommen. In der Anordnung nach Fig. 1 wird exemplarisch als für die Beanspruchung des Motors besonders aussagekräftiger Parameter der Motorstrom I beobachtet. Dieser wird mittels Stromsensor 5, z.B. einen Stromwandler, als der in der Zuführung 4 zum Elektromotor M fließende Strom erfaßt, geglättet, im Analog-Digital-Umsetzer ADU digitalisiert und der zentralen Prozessoreinheit CPU zugeführt. Die Prozessoreinheit CPU prüft nach einem im Programmspeicher PS enthaltenen Programm fortlaufend die eingehenden Ist-Werte des Motorstromes I auf Einhaltung vorgegebener Grenzwerte und registriert ferner Ein-, Um- und Ausschaltvorgänge, im Anschluß an Einschaltvorgänge auch die Hochlaufdauer des Elektromotors M. Die Prozessoreinheit CPU ordnet solchen ausgewählten Betriebsdaten, hier Stromdaten, Daten über den absoluten Zeitpunkt ihres Auftretens zu und legt sie über den Datenbus BUS 1 gemeinsam im Datenspeicher DS ab. Die absoluten Zeitdaten empfängt sie hierzu aus der Echtzeituhr EZU, etwa einer integrierten Echtzeituhr vom Typ RTC 58321 S-83 (Real Time Clock, Hersteller z.B. Firma Suwa Seiko, Japan), die von Sekunden bis zu Schaltjahren zählt und bei der gegebenen Genauigkeit von ca. ± 1 Sekunde pro Tag im Laufe von 10 Jahren eine maximale Gangabweichung von ca. ± 1 Stunde aufweist, wobei auch noch diese Gangabweichung reduzierbar ist, wenn in kürzeren als Zehnjahresabständen die gespeicherten Betriebs-und Zeitdaten ausgelesen werden und bei diesen Gelegenheiten der Stand der Echtzeituhr EZU korrigiert wird.

Überhaupt ohne galvanische Verbindung zu der den Elektromotor M speisenden Energiequelle kommt die in Fig. 1 dargestellte Schaltung zur Energiebelieferung der Energieversorgungseinheit EV aus: Eine im Ständer des Elektromotors M zusätzlich eingebrachte, generatorische Hilfswicklung H liefert genau immer dann Strom, wenn der Elektromotor M aktiv ist. Die Anpassung der serienmäßig herzustellenden Energieversorgungseinheit EV an verschiedene Motortypen - die an der Hilfswicklung unterschiedliche Spannungen entstehen lassen - kann durch Vorsehen mehrerer primärseitiger Anzapfungen an einem im Eingangsteil der Energieversorgungseinheit EV befindlichen Transformator gewährleistet werden.

Die Langzeitbatterie BAT sorgt dafür, daß während Stillstandszeiten des Elektromotors M - während derer die Energieversorgungseinheit EV selbst stromlos ist - die Echtzeituhr EZU unterbrechungsfrei weiterläuft und die Inhalte des Datenspeichers DS und des Programmspeichers PS -soweit diese überhaupt flüchtig sind - nicht verloren gehen. Der typische Stromverbrauch der Speicher und der Uhr beträgt zusammen beispielsweise 15 bis 60 Mikroampere, entsprechend ca. 4,3 Amperestunden in 10 Jahren. Lithiumzellen eignen sich wegen ihrer hohen Lebenserwartung, die im Zehnjahresbereich liegt, für diesen Einsatz besonders.

Die beschriebene Einrichtung MLUE ist aus technischen Gründen und zur Vermeidung von Manipulationen vorzugsweise vollständig, einschließlich der Schnittstelle SS, gekapselt und verplombt in einem geschlossenen Gehäuse untergebracht. Deshalb empfiehlt sich die Verwendung elektronischer Bauelemente, die nur geringe Verlustwärme entwickeln, z.B. Bauelemente in CMOS-Technik. Die Einrichtung MLUE wird zweckmäßig für längere Zeit, am besten für die gesamte Lebens- oder Einsatzdauer des Elektromotors M, letzterem eindeutig zugeordnet - d.h. nicht für verschiedene Motoren verwendet -, um klare Verhältnisse bei der Rekonstruktion der Motorbiographie aus den Daten der Einrichtung MLUE vorliegend zu haben. Besonders zweckmäßig ist die unmittelbare gegenständliche Anordnung eines die Einrichtung MLUE enthaltenden Gehäuses am Elektromotor M. Da die beschriebene Einrichtung MLUE nicht in den Betriebsablauf, etwa eine Regelung des Elektromotors M, einzugreifen braucht, lassen sich beliebige Motoren damit ausrüsten oder nachrüsten.

Um den Energieverbrauch in der und den Hardwareaufwand für die Einrichtung MLUE in wirtschaftlichem Rahmen zu halten, wird - obwohl technisch natürlich möglich - insbesondere dem Betreiber einer Mehrzahl zu überwachender Motoren nicht für jede einzelne Einrichtung MLUE eine eigene Datenanzeigeeinheit, z.B. ein eigenes Display oder gar ein eigener Drucker, vorgeschlagen, sondern ein externes Auslesegerät EXT, das über die Schnittstelle SS jeder Einrichtung MLUE die im Datenspeicher DS gespeicherten Betriebs- und Zeitdaten entnehmen, auf einer Anzeigeeineit ANZ zur Anzeige bringen und/oder auf einem Drucker DRU ausdrucken lassen kann. Hierzu kann über die Tasten des Tastenfeldes TAS des an die Schnittstelle SS angekoppelten externen Auslesegerätes EXT der Benutzer einen Dialog mit der Einrichtung MLUE und dem externen Auslesegerät EXT führen. Selbstverständlich darf der Datentransfer nur von autorisierten Personen durchgeführt werden. Er erfolgt über den bidirektionalen, im Fall einer seriellen Schnittstelle nur 1 Bit breiten Datenbus BUS 2.

Wenn während des Auslesevorgangs der Elektromotor M steht und infolgedessen die Energieversorgungseinheit EV nicht mit Energie beliefert, übernimmt in dieser Zeit das externe Auslesegerät EXT über den Netzverbindungsstecker NV, das Netzgerät NG und die Anschlußklemmen 6, 7 der Schnittstelle SS die Energieversorgung der Einrichtung MLUE. Wenn während des Auslesevorgangs der Elektromotor M läuft, stoppt die zentrale Prozessoreinheit CPU vorübergehend - für die Dauer der Kommunikation mit dem externen Auslesegerät EXT - die Verarbeitung und Speicherung von Betriebs- und Zeitdaten.

Nach Beendigung des Auslesevorgangs wird der Datenspeicher DS entweder gleich gelöscht und damit für die Aufnahme zukünftiger Betriebsdaten geräumt oder er wird - mit gleichem Effekt - für ein (allmähliches) Überschreiben mit neuen Daten freigegeben.

Unabhängig vom Auslesevorgang, aber aus praktischen Gründen zweckmäßigerweise in engem zeitlichem Zusammenhang, kann der Dialog mit der Einrichtung MLUE über das externe Auslesegerät EXT dazu genutzt werden, den Stand der Echtzeituhr EZU über deren Setzeingang 8 zu korrigieren, neue Kriterien (z.B. Stromgrenzwerte) für die Speicherung von Betriebsdaten vorzuschreiben oder neue Peripherie-Parameter, etwa für den Stromsensor 5, einzugeben. Dadurch kann die Einrichtung MLUE auch an neue Verwendungszwecke angepaßt werden.

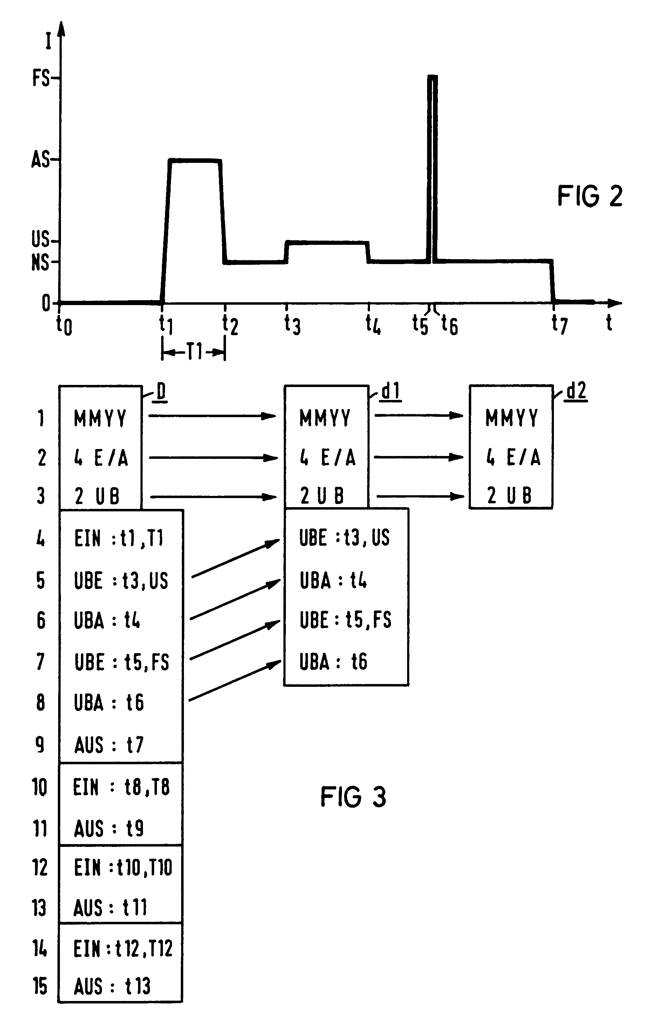

Auf die Stromgrenzwerte, die eine Speicherung von Betriebs- und Zeitdaten auslösen, sowie auf eine vorteilhafte Art dieser Speicherung wird unter Bezugnahme auf die Figuren 2 und 3 abschließend eingegangen. Der exemplarische Motorstromverlauf über der Absolutzeit t, nach Fig. 2, zeigt einen zum Zeitpunkt t1 von Null auf den Anlaufstrom AS hochschnellenden Motorstrom I, d.h. einen Einschaltvorgang. Dessen Zeitpunkt t1 und die Hochlaufdauer T1 werden als betriebswesentliches Ereignis im Datenspeicher DS abgespeichert, siehe Fig. 3, Datensatz D, Zeile 4. Der Hochlauf ist zum Zeitpunkt t2, dem Zeitpunkt der Rückkehr des Motorstromes I auf den Nennstrom NS, abgeschlossen.

Zum Zeitpunkt t3 setzt eine Überlastung des Elektromotors M ein, erkennbar am Anstieg des Motorstromes I auf den deutlich über dem Nennstrom NS liegenden Überlaststrom US. Zum Zeitpunkt t4 kehrt der Motorstrom I auf den Nennstrom NS zurück. Der Überlasteinsatz UBE wird mit Zeitpunkt t3 und dem maximalen während der Überlastung auftretenden Wert US des Überlaststroms abgespeichert, ebenso der Zeitpunkt t4 des Abklingens UBA der Überlastung, siehe Fig. 3, Datensatz D, Zeile 5/6.

Zum Zeitpunkt t5 ergibt sich durch eine Netzstörung, eine Fehleinschaltung des auslaufenden Elektromotors M, eine Umpolung des laufenden ELektromotors M oder ähnliche Ereignisse ein kurzzeitiger steiler Anstieg des Motorstroms I auf den Fehlsynchronisationsstrom FS bis zum Zeitpunkt t6. Die entsprechenden Überlastungsdaten UBE, UBA werden abgespeichert, siehe Fig. 3, Datensatz D, Zeile 7/8.

Schließlich sinkt zum Zeitpunkt t7 der Motorstrom I vom Nennstrom NS auf Null. Der damit konstatierte Ausschaltvorgang wird ebenfalls registriert, siehe Fig. 3, Datensatz D, Zeile 9. Weitere, in Fig. 2 nicht dargestellte Ein-Aus-Schaltvorgänge sind in Fig. 3 im Datensatz D in den Zeilen 10 bis 15 aufgeführt. Bemerkenswert ist noch, daß der normalerweise über dem Nennstrom NS liegende Anlaufstrom AS nur dann als Überlastfall registriert zu werden braucht, wenn er einen gesondert vorgebbaren Grenzwert für den Anlaufstrom übersteigt. Weiterhin wird der als Überlastfall registrierte Fehlsynchronisationsstrom FS gegebenenfalls erst beim Auslesen an seiner Höhe als solcher erkannt, d.h. mit einem ebenfalls gesondert vorgebbaren Grenzwert verglichen.

Falls im Laufe der Zeit die gesammelten Betriebs- und Zeitdaten D die Kapazität des Datenspeichers DS der Einrichtung MLUE zu erschöpfen drohen, wonach entweder keine weiteren Daten mehr aufgenommen werden könnten oder wertvolle, vorher gespeicherte Daten ersatzlos überschrieben würden, werden einer oder mehrere zunächst vollständige Datensätze D, insbesondere beginnend mit dem ältesten Datensatz, in einer oder mehreren Stufen komprimiert, insbesondere auf statistische Werte reduziert. In einer ersten Stufe können z.B. einzeln abgelegte Daten über Ein-Aus-Schaltvorgänge - siehe Fig. 3, Datensatz D, Zeilen 4 und 9 bis 15 - aufgegeben werden - siehe Datensatz d1 -, wenn die im Monatskopf unter MMYY abgelegte summarische Kenntnis über die in diesem Beispiel vier stattgefundenen Ein-Aus-Schaltvorgänge während des betreffenden Monats angesichts dessen möglicherweise langen Zurückliegens genügt.

In einem weiteren Schritt können unter denselben Gesichtspunkten erforderlichenfalls auch noch die Einzeldaten betreffend die zwei Überlastfälle UB aufgegeben werden, siehe Fig. 3, Übergang vom Datensatz d1 auf den Datensatz d2. Die Wirksamkeit dieser Datenreduktion läßt sich daran ermessen, daß danach ein 40 Kilobyte-Speicher überschlägig zur Speicherung von über 6000 Monatsköpfen, entsprechend 500 Jahren, ausreichen würde.

**Patentansprüche**

1. Betriebsdatenerfassungsvorrichtung mit einem Elektromotor, wobei

   a) der Elektromotor (M) im Ständer eine generatorische Hilfswicklung (H) aufweist, und
   b) die Betriebsdatenerfassungsvorrichtung (MLUE) aufweist
      b1) eine Energieversorgunseinheit (EV), welche an die generatorische Hilfswicklung (H) des Elektromotors (M) angeschlossen ist,
      b2) mindestens einen Dateneingang (5, ADU), der mit dem Elektromotor (M) zum Empfang von Betriebsdaten (I) verbunden ist,
      b3) eine zentrale Prozessoreinheit (CPU), einen Programmspeicher (PS), eine Echtzeituhr (EZU) und einen Datenspeicher (DS), wobei die zentrale Prozessoreinheit (CPU) den Zeitstand (t1,..., t13) der Echtzeituhr (EZU) den Betriebsdaten (I) zuordnet und beide Werte zusammen im Datenspeicher (DS) hinterlegt, und
      b4) mindestens einen Datenausgang (SS), womit die Daten aus dem Datenspeicher (DS) ausgegeben werden.

2. Vorrichtung nach Anspruch 1, **gekennzeichnet durch** eine Langzeitbatterie (BAT), insbesondere Lithiumzelle, zur Energieversorgung des Programmspeichers (PS), des Datenspeichers (DS) und/oder der Echtzeituhr (EZU) bei fehlender Energieversorgung aus der Energieversorgungseinheit (EV).

3. Vorrichtung nach Anspruch 1 oder 2, **gekenn-** zeichnet durch eine zumindest für einen Abschnitt der Lebens- oder Einsatzdauer des Elektromotors (M) bestehende eindeutige, un-mittelbar gegenständliche Zuordnung der Be-triebsdatenerfassungsvorrichtung (MLUE) zum Elektromotor (M).

4. Vorrichtung nach einem der vorangegenen Ansprüche **dadurch gekennzeichnet,** daß diese die Betriebsdaten (I) des Elektromotors (M) nur registriert und zur Ausgabe bereithält, und nicht in den Betriebsablauf des Elektromotors (M) eingreift.

5. Vorrichtung nach einem der vorangegangenen Ansprüche **dadurch gekennzeichnet,** daß die gespeicherten Daten (D; d1; d2) an ein externes Auslesegerät (EXT) ausgegeben werden.

6. Vorrichtung nach Anspruch 5, **dadurch gekennzeichnet,** daß die Energieversorgung der Betriebsdatenerfassungsvorrichtung (MLUE) während der Anschlußdauer des externen Auslesegerätes (EXT) über dieses gestellt wird.

**Claims**

1. An operating data acquisition device with an electric motor wherein

   a) the electric motor (M) has in the stator a generative auxiliary winding (H), and
   b) the operating data acquisition device (MLUE) has
      b1) a power supply unit (EV), which is connected to the generative auxiliary winding (H) of the electric motor (M),
      b2) at least one data input (5, ADU), which is connected to the electric motor (M) for receiving operating data (I),
      b3) a central processor unit (CPU), a program memory (PS), a real-time clock (EZU) and a data memory (DS), wherein the central processor unit (CPU) allocates the time reading (t1,.., t13) of the real-time clock (EZU) to the operating data (I) and both values are deposited together in the data memory (DS) and
      b4) at least one data output (SS), with which the data is fetched from the data memory (DS).

2. A device according to claim 1, characterised by a long-life battery (BAT), in particular a lithium cell, for power supply of the program memory (PS), of the data memory (DS) and/or of the real-time clock (EZU), when there is a defective power supply from the power supply unit (EV).

3. A device according to claim 1 or 2, characterised by a clear directly physical allocation of the operating data acquisition device (MLUE) to the electric motor (M), existing at least for one section of the lifetime or period of use of the electric motor (M).

4. A device according to one of the preceding claims, characterised in that this only registers the operating data (I) of the electric motor (M) and keeps them in readiness for delivery and does not intervene with the operating sequence of the electric motor (M).

5. A device according to one of the preceding claims, characterised in that the stored data (D; d1; d2) are delivered to an external read-out apparatus (EXT).

6. A device according to claim 5, characterised in that the power supply of the operating data acquisition device (MLUE) is set during the connecting duration of the external read-out apparatus (EXT) by way of this apparatus.

**Revendications**

1. Dispositif de détection de données de fonctionnement comportant un moteur électrique, et dans lequel
   a) le moteur électrique (M) possède, dans son stator, un enroulement auxiliaire générateur (H),
   b) le dispositif (MLUE) de détection de données de fonctionnement possède
      b1) une unité d'alimentation en énergie (EV), qui est raccordée à l'enroulement auxiliaire générateur (H) du moteur électrique (M),
      b2) au moins une entrée de données (5,ADU), qui est reliée au moteur électrique (M) pour la réception de données de fonctionnement (I),
      b3) une unité centrale formant processeur (CPU), une mémoire de programmes (PS), une horloge fonctionnant en temps réel (EZU) et une mémoire de données (DS), l'unité centrale formant processeur (CPU) associant l'heure (t1, ..., t13) de l'horloge en temps réel (EZU) aux données de fonctionnement (I) et mémorisant ces deux valeurs conjointement dans la mémoire de données (DS), et
      b4) au moins une sortie de données (SS), les données étant extraites de la mémoire de données (DS).

2. Dispositif suivant la revendication 1, caractérisé par une batterie de longue durée (BAT), notamment une batterie au lithium, pour l'alimentation en énergie de la mémoire de programmes (PS), de la mémoire de données (DS) et/ou de l'horloge fonctionnant en temps réel (EZU) dans le cas où l'alimentation en énergie fournie par l'unité d'alimentation en énergie (EV) est défaillante.

3. Dispositif suivant la revendication 1 ou 2, caractérisé par une association nette, parfaitement objective, existant au moins pour une section de la durée de vie ou de la durée d'utilisation du moteur électrique (M), entre le dispositif (MLUE) de détection des données de fonctionnement et le moteur électrique (M).

4. Dispositif suivant l'une des revendications précédentes, caractérisé par le fait que ce dispositif ne fait qu'enregistrer et maintenir à l'état prêt, pour leur délivrance, les données de fonctionnement (I) du moteur électrique (M) et n'intervient pas dans le cycle de fonctionnement du moteur électrique (M).

5. Dispositif suivant l'une des revendications précédentes, caractérisé par le fait que les données mémorisées (D; d1; d2) sont délivrées à un appareil externe de lecture (EXT).

6. Dispositif suivant la revendication 5, caractérisé par le fait que l'alimentation en énergie du dispositif (MLUE) de détection de données de fonctionnement est réglée pendant la durée de raccordement de l'appareil externe de lecture (EXT), par l'intermédiaire de cet appareil.

FIG 1

FIG 2

FIG 3